# EUROPÄISCHE PATENTANMELDUNG

(11) **EP 1 258 903 A2**
(43) Veröffentlichungstag der Anmeldung: **20.11.2002**
(21) Anmeldenummer: 01710048.8
(22) Anmeldetag: 15.09.2001
(51) Int. Cl.: H01J 27/02

(54) **Teilchenquelle**

(30) Priorität: 24.09.2000 DE 10047688
(71) Anmelder: Roentdek Handels GmbH, 65779 Kelkheim-Ruppertshain (DE)
(72) Erfinder: Spielberger, Lutz Dr., 60489 Frankfurt (DE); Bräuning-Demian, Angela Dr., 65830 Kriftel (DE); Penache, Maria Christina, 60486 Frankfurt (DE); Schmidt-Böcking, Horts Dr., 65779 Kelkheim (DE); Schösser, Sven, 60320 Frankfurt (DE); Jahnke, Till, 60318 Frankfurt (DE); Hohn, Oliver, 63584 Gründau (DE); Mergel, Volker Dr., 65191 Wiesbaden (DE)

(57) **Zusammenfassung**

Die Erfindung betrifft eine Teilchenquele, insbesondere eine Ionenquelle (99) für die Erzeugung angeregter Teilchen in gasförmigen Medien. Eine dielektrische, z.B. Kaptonfolie (11) ist beidseitig elektrisch leitfähig beschichtet (12, 13) und es wird zwischen den beiden Beschichtungen eine Spannung, vorzugsweise gepulst, angelegt. Durch die Spannung wird im Gasdurchfluss eine Gasentladung (14) gezündet. Durch eine Druckdifferenz zwischen den beiden Seiten (21, 22) der Folie expandiert das Gas von der Hochdruckseite auf die Niederdruckseite, vorzugsweise in einer Ultraschallexpansion (15), wodurch ein gerichteter kalter Strahl (32) aus angeregten Teilchen oder Ionen erzeugt wird.

## Beschreibung

### Gebiet der Erfindung

Die Erfindung betrifft eine Teilchenquelle im allgemeinen und eine Teilchenquelle für die Erzeugung angeregter Teilchen in gasförmigen Medien im speziellen.

### Hintergrund der Erfindung

Ionenquellen (IQ) spielen heute in vielen Bereichen der Physik und in der industriellen Anwendung (Plasmaabscheidung, Implantation, Ionenätzen von Mikrostrukturen etc.) eine wichtige Rolle. Die Anforderungen an solche Ionenquellen sind äußerst vielfältig z.B. bestimmte Ionenart oder Ladungszustand, hohe Intensität, hohe Brillanz, gepulster Betrieb etc. Allgemein ist jedoch das Ziel, Ionenquellen hoher Intensität mit guter Brillanz zu verbinden.
Bei bekannten Ionenquellen werden die Ionen in Plasmen erzeugt, die in der Regel im sub-millibar Druckbereich gezündet und betrieben werden. Dabei zeigt es sich, dass wegen dieser begrenzten Gas- und Plasma-Dichte nur Ionenströme mit Flächendichten von bis ca. 0,5 Ampere/cm² erreicht werden können. Eine ausführliche Beschreibung solcher bekannter Ionenquellen findet sich z.B. in B. Wolf, *Handbook of Ion Sources,* CRC Press, Boca Raton (1995) oder I. G. Brown, *The Physics and Technology of Ion Sources,* John Wiley & Sons, New York (1989), welche hiermit vollumfänglich zum Gegenstand der Beschreibung gemacht werden.

Die Brillanz oder Emittanz des Ionenstrahles wird durch die Temperatur der Ionen in der Quelle begrenzt. Diese Temperatur liegt bei den bekannten Ionenquellen typischerweise bei mehreren 1000° Celsius, was einer Energieunschärfe in allen drei Raumrichtungen von ca. 0,1 bis 1 eV (Elektronvolt) entspricht. Um Ionenstrahlen mit hoher Stromstärke zu erzeugen, werden hierbei in der Regel große Plasma-Volumina benötigt.

Ähnliches wie für Ionenquellen gilt auch für Teilchenquellen zur Erzeugung von Teilchen, z.B. Atomen oder Molekülen mit Elektronen in gebundenen angeregten Zuständen.

So werden z.B. Strahlen mit Atomen in gebundenen angeregten Zuständen zur Lithografie verwendet. Auch dies ist ein Anwendungsfeld für die vorliegende Erfindung.

### Zusammenfassung der Erfindung

Es ist daher eine Aufgabe der Erfindung eine Teilchenquelle für angeregte Teilchen zur Verfügung stellen, wobei die Teilchenquelle ein sehr kleines Volumen, einen hohen Teilchenstrom, eine geringe Emittanz und/oder eine hohe Brillanz, insbesondere eine geringe Energieunschärfe aufweist.

Eine weitere Aufgabe ist es, eine preiswerte und kompakte Teilchenquelle für angeregte Teilchen zur Verfügung zu stellen.

Eine weitere Aufgabe ist es, eine Teilchenquelle für großflächige angeregte Teilchenstrahlen zur Verfügung zu stellen.

Die Aufgabe der Erfindung wird in überraschend einfacher Weise bereits durch die in Anspruch 1 definierte Teilchenquelle gelöst.

Im Sinne der Erfindung umfasst der Begriff "angeregte Teilchen" sowohl Teilchen mit Elektronen in angeregten gebundenen Zuständen als auch Teilchen mit Elektronen in angeregten Kontinuumszuständen, also Ionen. Der Begriff "Teilchenquelle zum Erzeugen von angeregten Teilchen" umfasst also insbesondere eine Ionenquelle als auch eine Quelle für Teilchen, z.B. Atome oder Moleküle in gebundenen angeregten Zuständen. Letztere können zusätzlich auch ionisiert sein. Weiter umfasst der Begriff "angeregte Teilchen" im Sinne der Erfindung auch chemische Radikale, z.B. mittels einer Dissoziation, insbesondere von Molekülen. Die Teilchen sollen also insbesondere Träger potentieller Energie sein. Die Teilchen sind also derart angeregt, dass potentielle Energie. gespeichert und in einer Reaktion, z.B. an andere Teilchen abgebbar ist. Die Teilchen können aber auch Träger kinetischer Energie sein.

Die erfindungsgemäße Teilchenquelle erzeugt in vorteilhafter Weise einen gerichteten und kalten Strahl aus oder zumindest mit angeregten mikroskopischen Teilchen.

In einer bevorzugten Ausführungsform umfasst die erfindungsgemäße Teilchenquelle oder Ionenquelle ein erstes und ein zweites Gasvolumen auf einer ersten bzw. zweiten Seite einer Trennwand, wobei eine Druckdifferenz zwischen dem ersten und zweiten Gasvolumen besteht und Gas aus dem ersten in das zweite Gasvolumen durch zumindest eine Öffnung in der Trennwand strömt und beim Durchströmen in einer Gasentladung ionisiert oder angeregt wird. Insbesondere werden die Gasteilchen, -atome oder -moleküle elektronisch angeregt oder dissoziiert. Es sind mittels der erfindungsgemäßen Teilchenquelle also z.B. Helium-Ionen oder elektronisch angeregte metastabile Zustände, insbesondere von Heliumatomen oder Radikale, z.B. Sauerstoffradikale durch Dissoziation von O₂-Molekülen erzeugbar.

Eine vorteilhafte Ausführungsform der Teilchenquelle verwendet eine Trennwand, umfassend eine dielektrische oder elektrisch isolierende Basisschicht, eine elektrisch leitfähige erste Schicht auf der ersten Seite der Basisschicht und eine elektrisch leitfähige zweite Schicht auf der zweiten Seite der Basisschicht.

Solche Trennwände, insbesondere in Form einer flexiblen Folie sind leicht und preisgünstig herstellbar. Zwischen den beiden elektrisch leitfähigen Schichten ist eine Spannung anlegbar, welche aufgrund der kleinen Geometrie innerhalb der kleinen Öffnung extrem hohe elektrische Feldstärken erzeugbar macht. Die Feldstärken im Bereich der Öffnung betragen mindestens etwa 10⁴, 10⁵, 10⁶, 10⁷ oder sogar 10⁸ V/cm. Hierzu sind lediglich relativ geringe Spannungen in der Größenordnung von etwa 1 bis 1000 Volt notwendig. Aufgrund der hohen Feldstärken kann die Teilchenquelle bei hohen Drücken von bis zu 10⁻³, 10⁻², 10⁻¹, 10, oder 10² bar auf der ersten Seite der Trennwand betrieben werden.

Bei einer besonders vorteilhaften Ausführungsform der Erfindung beträgt die Druckdifferenz zwischen der ersten und zweiten Seite der Trennwand zumindest ein, zwei, drei, vier fünf oder sechs Zehnerpotenzen. Dadurch expandiert das Gas beim Durchströmen durch die Öffnung im wesentlichen adiabatisch isochor. Dadurch wird die gesamte Enthalpie des Gases in gerichtete Bewegung umgewandelt, so dass die Gasatome eine mittlere Geschwindigkeit v = (5kT/m)^{1/2}, wobei k die Boltzmann-Konstante, T die Gastemperatur und m die Teilchenmasse sind, erhalten. Dabei kühlt das Gas auf Temperaturen bis in den milliKelvin-Bereich ab. Es entsteht ein Ulltraschallgasjet. Ultrschallgasjets sind dem Fachmann grundsätzlich bekannt. Der Ultraschallgasjet wird nun erfindungsgemäß im Bereich der Öffnung durch Elektronensoßionisation ionisiert, wodurch ein extrem kalter und gerichteter Teilchen- oder Ionenstrahl entsteht.

Bei einer bevorzugten Weiterbildung der Erfindung wird der kälteste innere Teil des Teilchenstrahls durch eine Blende oder einen Skimmer herausgeschält, wodurch eine noch geringere Energieunschärfe erzeut wird. Um besonders geringe Teilchentemperaturen zu erreichen wird das Gas in dem ersten Gasvolumen vorzugsweise auf unter 100, 70, 30, 20, oder 10 Kelvin gekühlt.

Besonders vorteilhaft wird mit einem Mischgas aus Trägergas, und einem Arbeitsgas, wobei vorzugsweise im wesentlichen lediglich die Atome oder Moleküle des Arbeitsgases ionisiert werden, gearbeitet. Das Trägergas bestimmt im wesentlichen die thermodynamischen Eigenschaften der Gasexpansion. Zum Beispiel ist Helium aufgrund seiner geringen Atommasse und seinem hohen Anregungs- und Ionisationspotential besonders gut als Trägergas geeignet, es kühlt während der Expansion das Arbeitsgas. Außerdem können in Helium wegen dessen hoher elektronischer Anregungsenergie die bei der Gasentladung entstehenden und daraufhin durch das elektrische Feld beschleunigten Elektronen trotz des hohen Gasdrucks eine große kinetische Energie aufnehmen. Das Arbeitsgas weist ein wesentlich geringeres Anregungs- und Ionisationspotential als Helium auf, so dass im wesentlichen lediglich das Arbeitsgas angeregt und/oder ionisiert wird. Durch Wahl des Mischverhältnis von Träger- und Arbeitsgas kann die mittlere kinetische Energie des Elektronen und damit die Anregung und/oder Ionisation des Arbeitsgases gezielt eingestelt werden.

Durch Kühlung des Trägergases wird die transversale Impulsunschärfe des Gases und damit des Teilchenstrahls weiter verringert, so dass der Teilchenstrahl eine extrem gute transversale Brillanz besitzt.

Eine bevorzugte Weiterbildung der Erfindung verwendet sogenannte Mikrostrukturelektroden-Folien. Eine Mikrostrukturelektrode (MSE) umfasst eine, mehrere oder viele Mikro-Öffnungen. Im Falle von mehreren oder vielen Öffnungen sind diese vorzugsweise als regelmäßige flächenhafte Matrix angeordnet. Diese ist preisgünstig, großflächig, mit geringem Abstand zwischen den Öffnungen und sehr kleinen Öffnungen herstellbar. Bei dieser Ausführungsform wird ein großflächiges Plasma durch eine Vielzahl von Poren erzeugt. Dadurch werden Ionenstromdichten von mindestens 10⁻³, 10⁻², 10⁻¹, 10, 100 oder 1000 Ampere/cm² bei Gleichstrom oder gepulstem Betrieb erzeugt.

Im Folgenden wird die Erfindung anhand bevorzugter Ausführungsformen und unter Bezugnahme auf die Figuren näher erläutert.

Hierbei werden im folgenden beispielhaft erfindungsgemäße Ionenquellen vorgestellt. Es ist dem Fachmann aber ersichtlich, dass mit den gezeigten Ionenquellen auch Teilchen, insbesondere Atome oder Moleküle mit Elektronen in gebundenen angeregten Zuständen erzeugt werden können, welche z.B. durch Elektronenstoßanregung oder Elektroneneinfang entstehen.

### Kurzbeschreibung der Figuren

Es zeigen:
- Fig. 1a: eine Schnittzeichnung durch eine erste Ausführungsform einer Einzelpore,
- Fig. 1b: eine Schnittzeichnung durch eine zweite Ausführungsform einer Einzelpore,
- Fig. 2: eine perspektivische Ansicht eines Ausschnitts einer MSE-Folie,
- Fig.3: eine Schnittzeichnung der Potentialverteilung in einer Pore gemäß einer Computersimulation,
- Fig. 4: eine schematische Schnittzeichnung einer ersten Ausführungsform der erfindungsgemäßen Ionenquelle,
- Fig. 5: eine schematische Schnittzeichnung einer Ausführungsform der erfindungsgemäßen Multielektrodenpore
- Fig. 6: eine schematische Schnittzeichnung durch eine zweite Ausführungsform der Erfindung,
- Fig. 7: eine Draufsicht auf zwei verschiedene Porenformen vor (obere Reihe) und nach dem Betrieb (untere Reihe),
- Fig. 8: eine Draufsicht auf eine Pore mit integriertem passivem Widerstand,

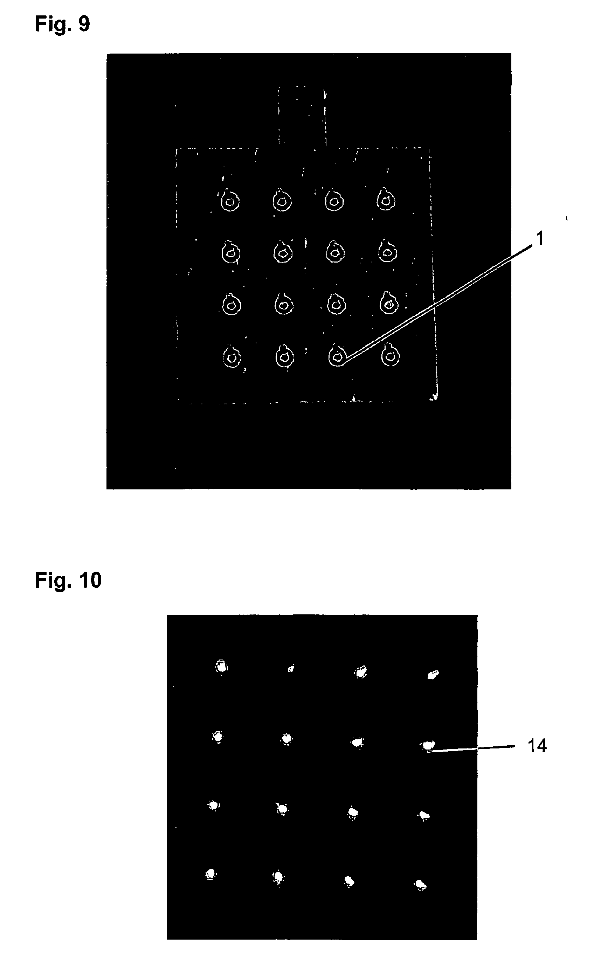

- Fig. 9: eine Draufsicht auf eine MSE-Folie mit 16 Poren und
- Fig. 10: eine Draufsicht auf die MSE-Folie aus Fig. 9 mit leuchtenden Mikroglimmentladungen.

### Detaillierte Beschreibung der Erfindung

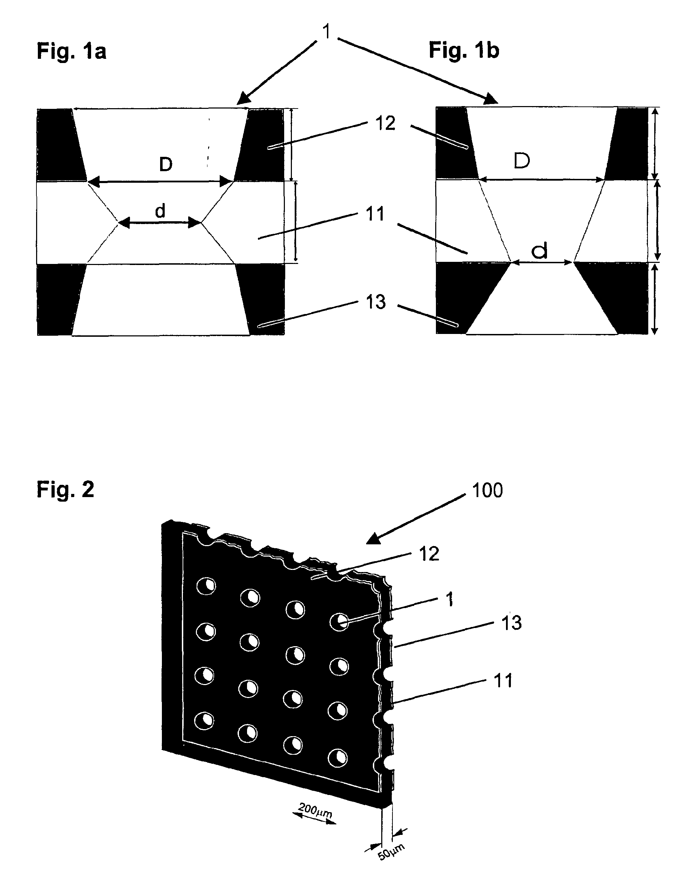

Fig. 1a zeigt eine erste bevorzugte Ausführungsform einer Einzelpore 1 mit einer Basisschicht 11 von 50 µm starkem Kapton oder etwa 300 µm starkem Keramik mit elektrisch leitfähigen Elektrodenschichten 12, 13 auf beiden Seiten der Basisschicht 11. Die Stärke der Elektrodenschichten 12, 13 beträgt 40 bis 200 µm Kupfer oder Kupfer-Nickel. Die elektrisch leitfähige Schicht 12 auf der Hochdruckseite 21 wird als Anode 12 und die Schicht 13 auf der Niederdruckseite 22 der Pore 1 als Kathode 13 gefahren. Der Lochdurchmesser beträgt an der engsten Stelle d, welche bei dieser ersten Pore in der Mitte der Isolationsschicht liegt, zwischen etwa 10 und 100 µm. Der Durchmesser an der Grenze zwischen Elektrodenschicht und Basisschicht D beträgt 70 µm bis 150 µm. Der Lochabstand bei Verwendung einer Vielzahl solcher Poren 1 beträgt ca. 100 µm bis ca. 1 mm.

Fig. 1b zeigt eine zweite Ausführungsform einer Pore 1, welche sich dadurch von der ersten Ausführungsform der Pore in Fig. 1a unterscheidet, dass sich der kleinste Durchmesser d an der Grenze zwischen der Basisschicht 11 und der Kathodenschicht 13 befindet.

Jede einzelne Mikroionenenquelle wird aus einer Mikropore 1 in einer dünnen Folie gebildet. Diese hat nur ein Volumen von weniger als etwa 10⁻⁵ cm³ und kann bei Drucken auf der Hochdruckseite von einigen Millibar bis einigen Bar betrieben werden. Die zur Erzeugung der Ionen in einer Gasentladung 14 notwendigen elektrischen Spannungen liegen hier bei wesentlich unter 1000 V und betragen vorzugsweise 200 bis 450 V. Aufgrund der speziellen Geometrie des Mikroionenquellensystems z.B. bei einer Pore 1 mit ca. 100 µm Durchmesser und ca. 250 µm Länge mit sehr scharfen Elektrodenkanten werden so hohe Feldstärken erreicht, dass die Entladung bei Anlegen der Spannung sofort und selbsttätig zündet. Dadurch werden sehr geringe Verzögerungszeiten von etwa
< 1 µsec erreicht. Die gemessene Leistungsdichte pro Mikroentladung (je Pore 1) kann im Gleichstrombetrieb von milliWatt bis zu mehreren 100 Watt betragen. Damit können Leistungsdichten von mehr als 1, 10 oder 100 kW/cm² erreicht werden. Im Pulsbetrieb sind sogar noch höhere Leistungen möglich.

Fig. 2 zeigt einen Ausschnitt aus einer MSE-Folie 100 mit 16 Poren 1.

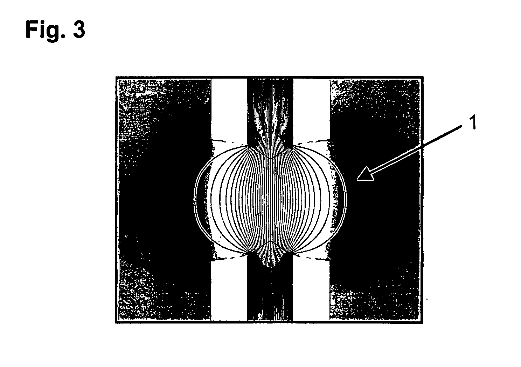

Fig. 3 zeigt beispielhaft die simulierte Potentialverteilung in einer Pore 1 einer MSE-Folie.

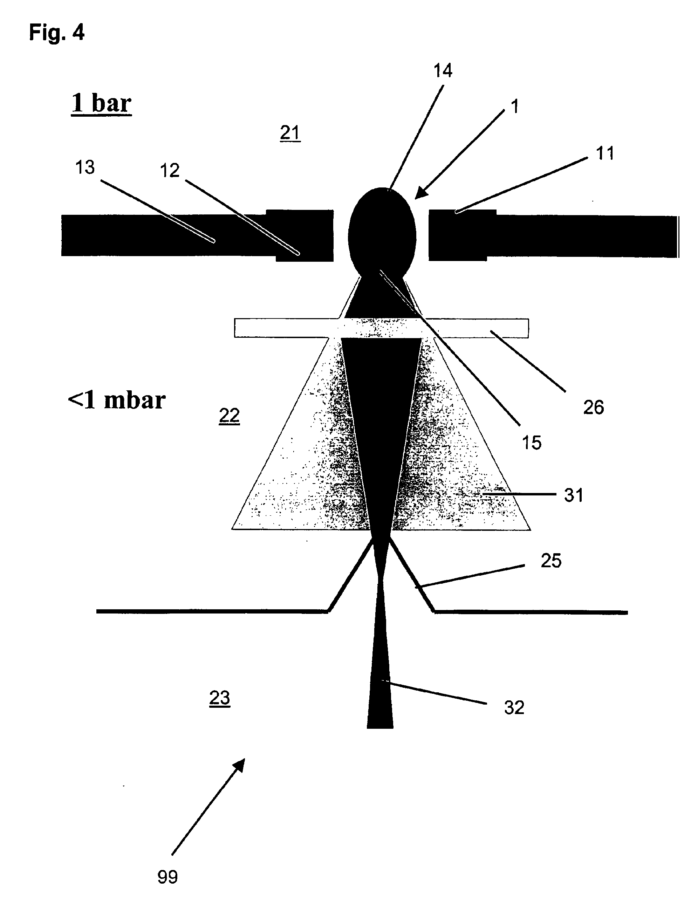

Fig. 4 zeigt einen Ultraschallgasjet mit der erfindungsgemäßen Mikro-Gasentladung. Dadurch wird eine Ionenquelle 99 mit hoher Intensität und ausgezeichneter Emittanz zur Verfügung gestellt. Gas strömt von der Hochdruckseite 21 durch eine Pore 1 auf die Niederdruckseite 22 und expandiert dabei adiabatisch isochor. Der dabei entstehende Ultraschallgasjet 15 tritt zum Teil durch den Skimmer 25 in das Volumen 23.

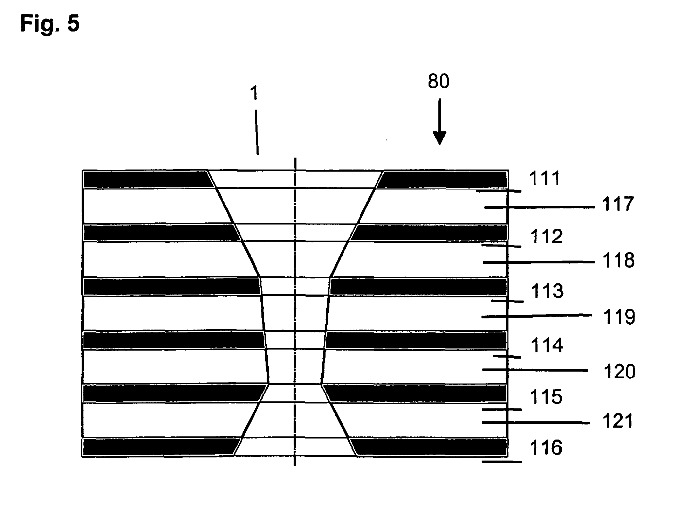

Wie in Fig. 4 dargestellt, beträgt der Druck auf der Anodenseite, d.h. der Hochdruckseite 21 (Vakuumstufe 21) der Pore 1 bei dieser Ausführungsform der Erfindung etwa 1 bar und strömt durch die Pore 1, wobei sich ein sehr kalter Ultraschallstrahl 15 ausbildet, dessen Gas eine innere Temperatur von weniger als 1°K hat. Auf der Kathodenseite, d.h. Niederdruckseite 22 treten je nach Pumpleistung in dem Volumen 22 Drucke zwischen 10⁻³ bis einige 10⁻¹ mbar auf. Die elektrische Entladung 14 brennt in der Pore 1 und erzeugt durch Elektronstoßionisation in einer Gasentladung 14 Ionen. Das zu ionisierende Gas, d.h. das Arbeitsgas, bei dieser Ausführungsform z.B. O₂ oder Kr wird dem Trägergas, hier etwa neunzig Volumenprozent Helium beigemischt. Es kann aber grundsätzlich jedes Träger- und jedes Arbeitsgas verwendet werden. In der Hochdruckstufe 21 wird das Gasgemisch auf ca. 20°K vorgekühlt. Die Ionisationsenergien der exemplarischen Arbeitsgase O₂ und Kr sind wesentlich niedriger als die des Helium, daher wird im wesentlichen lediglich das Arbeitsgas ionisiert. Bei den Stößen in der Pore 1 während der Ausbildung des Ultraschallstrahls 15 werden die Ionen durch das He gekühlt, wegen der stark unterschiedlichen Ionisationspotentiale findet aber kaum Ladungsaustausch mit den Heliumatomen statt. Transversal werden die Ionen im wesentlichen auf die innere Temperatur des He-Ultraschallstrahles 15 heruntergekühlt und erreichen so transversale Temperaturen von unter 1°K. Longitudinal hängt die Ionenstrahltemperatur vor allem vom Entstehungsort der Ionen in der Pore ab, da je nach Entstehungsort sie sich auf leicht unterschiedlichem Potential befinden. Durch Verlängerung der Pore 1 oder Aufbau einer Multielektrodenpore 80 (Fig. 5) kann eine weiter verbesserte Kühlung mit dem He-Trägergas und elektrische Fokussierung der Ionen auch in der longitudinalen Richtung erreicht werden. Damit wird auch die longitudinale Emittanz reduziert. Je nach Druck in der Stufe 22, wird der Abstand zwischen Ausgang der Pore 1 auf der Kathodenseite 22 und Ionenstrahlabschäler 25 oder Skimmer optimal eingestellt, damit der Ultraschallstrahl 15 nicht zerstört wird. Der Abstand beträgt etwa wenige mm bis etwa 1,5 cm. Der Ultraschallstrahl 15 tritt gerichtet, aber nicht notwendigerweise fokussiert aus der Pore 1. Je nach Größe des Skimmers 25, bei dieser Ausführungsform etwa 1 mm Durchmesser oder kleiner, wird nur ein winziger Anteil des Trägergas 31 durch die Pore treten, wohingegen ein größerer Anteil der Ionen wegen ihrer vorzüglichen Transversalemittanz und Fokussierung durch den Skimmer 25 tritt. Mit Hilfe einer Fokussierungslinse 26 zwischen der Pore 1 und dem Skimmer 25 wird ein besonders grosser Anteil des Ionenstroms 32 durch den Skimmer geführt.

Die Ionenquelle 99 ist umschlossen von einer Vakuumkammer (nicht gezeigt), welche durch eine Mehrzahl von Pumpen (nicht gezeigt) evakuiert wird. Vorzugsweise wird das Gasvolumen 21 durch einen Kryostaten (nicht gezeigt) gekühlt.

Fig. 5 zeigt eine weitere Ausführungsform einer erfindungsgemäßen Pore 1, nämlich eine Multielektrodenpore 80. Durch mehrere, von Basis- oder Isolatorschichten 117, 118, 119, 120, 121 getrennte, hintereinander angeordnete und unabhängig voreinander ansteuerbare, in dieser Ausführungsform sechs Elektroden 111, 112, 113, 114, 115, 116 wird innerhalb der Pore 80 das elektrische Feld in vielfältiger Weise modelliert. Jede einzelne Stufe, umfassend eine Isolatorschicht und die zwei angrenzenden leitfähigen Schichten oder Elektroden, stellt eine wie oben beschriebene Mikropore dar.

Der Durchmesser verengt sich in Stromrichtung von der Elektrode 111 bis zur Elektrode 113, verengt sich mit geringerer Steigung von der Elektrode 113 bis zur Elektrode 115 und erweitert sich von der Elektrode 115 bis zur Elektrode 116, wobei der Durchmesser bei der Elektrode 116 kleiner ist als bei der Elektrode 111. Durch diese bevorzugte Geometrie der Öffnung fällt der Druck über etwa eine Größenordnung innerhalb des Bereichs zwischen den Elektroden 111 und 113 ab. Zwischen den Elektroden 113 und 116 bildet sich der eigentliche Ultraschalljet aus. Hier werden die Ionen durch elastische Stöße gekühlt. Durch Anlegen geeigneter Spannung an die Elektroden wird der Ionenstrahl optimal transportiert. Durch die innere Geometrie der Pore 80 wird das Kühlverhalten bei der Expansion gezielt beeinflusst.

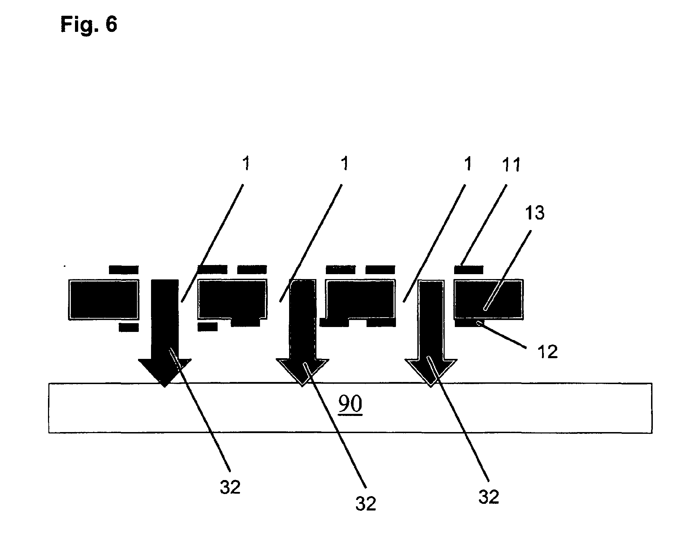

Fig. 6 zeigt eine Multiporenionenquelle 100. Hierbei kann jede Pore 1 einzeln angesteuert werden. In jeder Pore kann unabhängig voneinander eine Entladung im Submikrosekundenbereich ein- und wieder ausgeschaltet werden. Eine solche Multiporenionenquelle eignet sich insbesondere zur Oberflächenreinigung und -beschichtung eines Substrats 90 bei einem erzeugbaren Ionenstrom von mehr als 10¹⁵ Ionen/sec pro Pore. Wegen der sehr guten Emittanz des Ionenstrahls kann z.B. eine makroskopische Maske auf das Substrat 90 im Nanometer-Bereich verkleinert werden und Ionenstrahlserigraphie oder Lithografie im atomaren Bereich ist möglich.

Systematische Untersuchungen mit Einzelporen 1 haben gezeigt, dass pro Pore 1 eine Entladung über Stunden von ca. 3 bis 5 Watt bei 200 V Entladungsspannung und 15 bis 25 mA Strom betrieben werden kann. Diese Werte wurden mit Folien, welche als Basisschicht 13 Kapton verwenden, erreicht. Keramikbasierte Folien sollten noch langlebiger sein.

Diese Entladungen können extrem schnell im Pulsbetrieb einund ausgeschaltet werden. Es werden Schaltzeiten von unter 10 oder 1 µsec erreicht. Ein- und Ausschaltzeiten in bekannten Ionenquellen sind je nach Plasmageometrie 14 mehr als Faktor hundert länger.

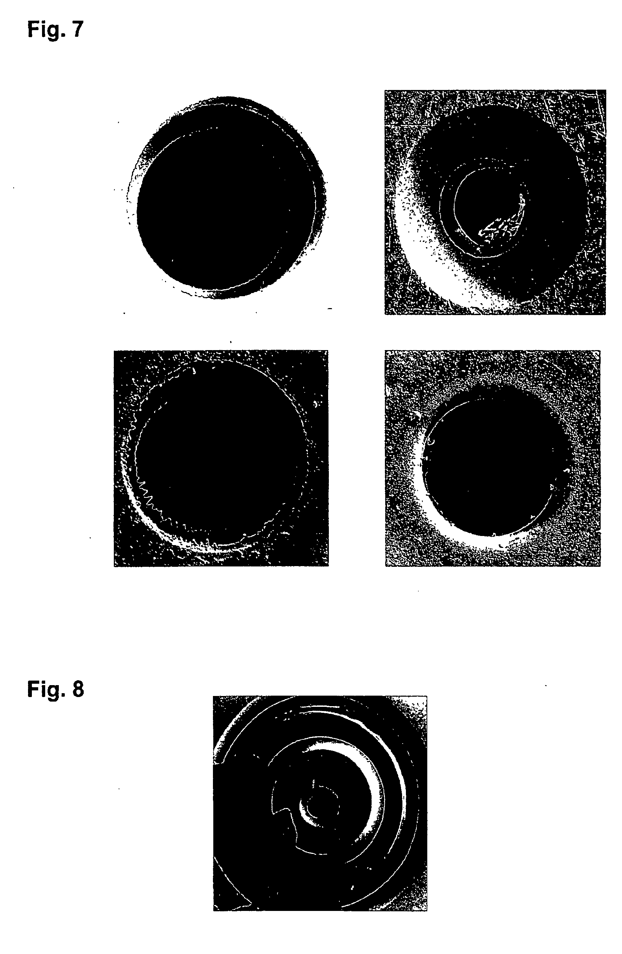

Fig. 7 zeigt eine Draufsicht auf zwei verschiedene MSE-Porenformen vor (obere Reihe) und nach dem Betrieb (untere Reihe) von einigen Stunden.

Die einzeln ansteuerbaren Mikroentladungen 14 können eng beieinander flächenhaft integriert werden, so dass mehr als 10³ Poren/cm² erreicht wurden. Im Prinzip ist die Größe der Fläche nahezu unbegrenzt. Die Limitierung wird im wesentlichen lediglich von der Leistung der Pumpe in der Vakuumstufe 22 bestimmt, um das recyclebare He-Trägergas abzupumpen, sowie durch den thermische Belastung pro Fläche, welche zur Zerstörung die termische Belastung Porenfolie 100 führen kann.

Das Volumen einer Mikroionenenquelle mit etwa 1000 Poren misst nur etwa eine Fläche von ca. (4 x 4)mm² und hat eine Dicke von ca. 0,3 mm. Das geometrische Volumen der gekühlten Hochdruckstufe 21 wird an die gewünschte Temperatur angepasst, es liegt vorzugsweise im Bereich von einigen cm³. Mit der Ionenquelle 99 werden bei Transversaltemperaturen von etwa 1°K oder weniger lonenströme von einigen 100 mA bis 1 A erreicht. Außerdem liegt die angelegte Spannung nur bei einigen 100V, bei dieser Ausführungsform 200 bis 450 V.

Damit wird eine Ionenquelle 99 vorgestellt, die basierend auf Mikrostrukturelektroden mit Ultraschallexpansion und Ultraschallionenkühlung sehr hohe Leistungsdichten bei höchster Brillanz und sehr schnellen Ansteuerzeiten bietet und außerdem von der Größe her als ein Mikrosystem zu gelten hat. Ein entscheidender physikalischer Unterschied zu herkömmlichen Ionenquellen resultiert aus der extrem hohen Feldstärke auf Grund der Mikrostrukturgeometrie, so dass bei einem hohen Druck von etwa 1 bar Entladungen, (Glimmentladungen) gezündet werden können und dies mit relativ geringen Spannungen.

## Patentansprüche

1. Teilchenquelle (99) zum Erzeugen von angeregten Teilchen, umfassend
eine Trennwand (11) mit zumindest einer Öffnung (1),
wobei die Öffnung ein erstes Volumen (21) auf einer ersten Seite der Trennwand mit einem zweiten Volumen (22) auf einer zweiten Seite der Trennwand verbindet und
erste Teilchen,
wobei die ersten Teilchen sich aus dem ersten Volumen (21) durch die Öffnung (1) in das zweite Volumen (22) bewegen, Energie auf die ersten Teilchen übertragen wird und zumindest einige der ersten Teilchen in angeregte Zustände übergehen.

2. Teilchenquelle (99) nach Anspruch 1, wobei die ersten Teilchen in angeregten Zuständen Ionen und/oder Teilchen in gebundenen angeregten Zuständen umfassen.

3. Teilchenquelle (99) nach Anspruch 1 oder 2, wobei das erste Volumen (21) ein erstes Gasvolumen und das zweite Volumen (22) ein zweites Gasvolumen umfassen, wobei eine Druckdifferenz zwischen dem ersten und zweiten Gasvolumen (21, 22) besteht und Gas aus dem ersten (21) in das zweite Gasvolumen (22) durch die Öffnung (1) strömt und beim Durchströmen innerhalb der Öffnung in einer Gasentladung angeregt oder ionisiert wird.

4. Teilchenquelle (99) nach einem der vorstehenden Ansprüche, wobei die Trennwand (11) eine dielektrische Basisschicht (11), eine elektrisch leitfähige erste Schicht (12) auf der ersten Seite (21) der Basisschicht (11) und eine elektrisch leitfähige zweite Schicht (13) auf der zweiten Seite (22) der Basisschicht (11) umfasst.

5. Teilchenquelle (99) nach Anspruch 4, wobei eine elektrische Spannung zwischen der ersten und zweiten leitfähigen Schicht (12, 13) anlegbar ist, durch welche Spannung eine Gasentladung mittels Elektronenstoßionisation im Bereich der Öffnung (1) erzeugt wird.

6. Ionenquelle (99) nach Anspruch 4 oder 5, wobei eine gepulste elektrische Spannung zwischen der ersten und zweiten leitfähigen Schicht (12, 13) anlegbar ist.

7. Teilchenquelle (99) nach einem der vorstehenden Ansprüche, wobei im Bereich der Öffnung (1) eine elektrische Feldstärke von mindestens etwa 10⁴, 10⁵, 10⁶, 10⁷ oder 10⁸ V/cm erzeugbar ist.

8. Teilchenquelle (99) nach einem der vorstehenden Ansprüche, wobei das Gas beim Durchströmen durch die Öffnung (1) im wesentlichen adiabatisch expandiert.

9. Teilchenquelle (99) nach einem der vorstehenden Ansprüche, wobei das Gas durch die Öffnung (1) im wesentlichen Ultraschall-expandiert.

10. Teilchenquelle (99) nach einem der vorstehenden Ansprüche, wobei das Gas ein Mischgas (He + Kr) ist.

11. Teilchenquelle (99) nach einem der vorstehenden Ansprüche, wobei das Gas im wesentlichen aus einem Trägergas (He) und einem Arbeitsgas (Kr, O₂) besteht.

12. Teilchenquelle (99) nach einem der vorstehenden Ansprüche, wobei aufgrund verschiedener Ionisationspotentiale des Träger- und des Arbeitsgases, des Mischverhältnisses der Gase und/oder der Geometrie der Öffnung im wesentlichen das Arbeitsgas angeregt oder ionisiert wird.

13. Teilchenquelle (99) nach einem der vorstehenden Ansprüche, wobei die Expansionsgeschwindigkeit im wesentlichen von dem Trägergas (He) bestimmt wird.

14. Teilchenquelle (99) nach einem der vorstehenden Ansprüche, wobei das Gas auf der ersten Seite der Trennwand (13) auf unter etwa 100, 70, 30, 20, oder 10 Kelvin gekühlt ist.

15. Teilchenquelle (99) nach einem der vorstehenden Ansprüche, wobei die Druckdifferenz zwischen dem ersten und zweiten Volumen etwa mindestens ein, zwei, drei, vier, fünf oder sechs Zehnerpotenzen beträgt.

16. Teilchenquelle (99) nach einem der vorstehenden Ansprüche, wobei der Druck auf der ersten Seite (21) der Trennwand (11) mindestens 10⁻², 10⁻¹, 10 oder 10² bar und/oder der Druck auf der zweiten Seite (22) der Trennwand (11) höchstens 10⁻⁴, 10⁻⁵, 10⁻⁶, 10⁻⁷ oder 10⁻⁸ bar beträgt.

17. Teilchenquelle (99) nach einem der vorstehenden Ansprüche, wobei das Gas im wesentlichen gerichtet aus der Öffnung (1) ausströmt.

18. Teilchenquelle (99) nach einem der vorstehenden Ansprüche, wobei ein entstehender Ionenstrahl (32) mittels elektrischer und/oder magnetischer Felder auf der zweiten Seite der Trennwand von nichtionisierten und/oder angeregten Teilchen (31) separierbar ist.

19. Teilchenquelle (99) nach einem der vorstehenden Ansprüche, wobei einen auf der zweiten Seite (22) der Trennwand (11) in vorbestimmtem Abstand von der Öffnung (1) angeordneten Abschäler (25).

20. Teilchenquelle (99) nach einem der vorstehenden Ansprüche, wobei ein entstehender Ionenstrahl (32) mittels elektrischer und/oder magnetischer Felder fokussierbar ist.

21. Teilchenquelle (99) nach einem der vorstehenden Ansprüche, wobei eine Mehrzahl von Öffnungen (1) in der Trennwand (13) vorgesehen sind.

22. Teilchenquelle (100) nach Anspruch 21, wobei an den Öffnungen (1) verschiedene Spannungen anlegbar sind.

23. Teilchenquelle (100) nach Anspruch 21 oder 22, wobei durch verschiedene Spannungen an den Öffnungen (1) verschiedene mittlere Ladungszustände der Ionen erzeugbar sind.

24. Teilchenquelle (80), insbesondere nach einem der vorstehenden Ansprüche umfassend
eine dielektrische erste Basisschicht (117) mit einer Öffnung (1),
eine erste Elektrode (111) auf einer ersten Seite der ersten Basisschicht (117) und
eine zweite Elektrode (112) auf einer zweiten Seite der ersten Basisschicht (117).

25. Teilchenquelle (80) nach Anspruch 24 umfassend
eine dielektrische zweite Basisschicht (118) und
eine dritte Elektrode auf einer ersten Seite der zweiten Basisschicht.

26. Teilchenquelle (80) nach Anspruch 25, wobei die zweite Elektrode (112) zwischen der ersten und zweiten Basisschicht (117, 118) angeordnet ist.

27. Teilchenquelle (80) nach Anspruch 25 oder 26, wobei die erste Elektrode (111), die erste Basisschicht 117, die zweite Elektrode (112), die zweite Basisschicht 118 und die dritte Elektrode (113) sich sandwichartig aufeinanderfolgend berühren.

28. Teilchenquelle (80) nach einem der Ansprüche 25 bis 27,
wobei die Öffnung (1) durchgängig durch die erste, zweite und dritte Elektrode (111, 112, 113) sowie die erste und zweite Basisschicht (117, 118) ist.

29. Teilchenquelle (80) nach einem der Ansprüche 25 bis 28,
wobei die Öffnung (1) an der ersten und zweiten Eletrode (111, 112) und/oder and der zweiten und dritten Elektrode (112, 113) verschiedene Durchmesser hat.

30. Vorrichtung, umfassend
eine oder mehrere Teilchenquellen nach einem der Ansprüche 1 bis 29,
eine Vakuumkammer,
eine oder mehrere Vakuumpumpen und
insbesondere eine Kühleinrichtung für das erste Gasvolumen.
